# DEMANDE DE BREVET EUROPEEN

(11) **EP 3 115 680 A1**
(43) Date de publication de la demande: **11.01.2017**
(21) Numéro de dépôt: 16177280.1
(22) Date de dépôt: 30.06.2016
(51) Int. Cl.: F21S 8/10, F21K 99/00, F21V 9/16, F21V 13/14, H01S 5/00

(54) **DISPOSITIF OPTIQUE COMPORTANT AU MOINS UN CONVERTISSEUR DE LONGUEUR D'ONDE, MODULE LUMINEUX ET DISPOSITIF D'ÉCLAIRAGE POUR VÉHICULE AUTOMOBILE COMPORTANT UN TEL DISPOSITIF**

(30) Priorité: 08.07.2015 FR 1556475
(71) Demandeur: VALEO VISION, 93012 Bobigny Cedex (FR)
(72) Inventeur: ALBOU, Pierre, 75013 Paris (FR); COURCIER, Marine, 75011 Paris (FR)

(57) **Abrégé**

Dispositif optique comportant :
- un élément optique convertisseur de longueur d'onde (21), formé d'un premier milieu optique ayant un premier indice de réfraction, l'élément convertisseur étant configuré pour recevoir un faisceau lumineux incident (1) sur une première (23) de ses faces et pour convertir le faisceau lumineux incident en un faisceau lumineux converti ;
- un élément optique réfléchissant (22), disposé sur une deuxième (24) des faces du convertisseur, la deuxième face étant opposée à la première face, l'élément réfléchissant étant configuré pour réfléchir le faisceau lumineux converti ;
- un élément optique dit primaire (3), formé d'un deuxième milieu optique ayant un deuxième indice de réfraction sensiblement identique au premier indice de réfraction, l'élément primaire ayant une première (33) de ses faces disposée à proximité de la première face de l'élément convertisseur (21), l'élément primaire (3) étant configuré pour recevoir le faisceau lumineux incident (1) et le transmettre au convertisseur (21), l'élément primaire (3) ayant une deuxième (34) de ses faces formant la face de sortie de l'élément primaire pour le faisceau lumineux converti, la face de sortie de l'élément primaire étant configurée pour minimiser les réflexions parasites du faisceau lumineux converti sur elle-même.

## Description

### DOMAINE TECHNIQUE DE L'INVENTION

L'invention concerne un dispositif optique comportant au moins un convertisseur de longueur d'onde, ainsi qu'un module lumineux incorporant un tel dispositif et un dispositif d'éclairage tel qu'un projecteur ou un feu signalisation pour véhicule automobile comportant un tel module.

### ARRIERE PLAN TECHNIQUE DE L'INVENTION

Dans le domaine de l'éclairage automobile, il est connu, lorsque l'on utilise des diodes laser comme source de lumière, d'utiliser un élément optique convertisseur de longueur d'onde, appelé aussi phosphore, pour obtenir de la lumière blanche à partir de la lumière monochromatique, souvent bleue, fournie par la source laser.
Le faisceau laser, après d'éventuels traitements optiques comme balayage et/ou diffusion, vient donc éclairer le convertisseur. Le faisceau lumineux issu de convertisseur est ensuite, dans le cadre d'une telle application, transmis à un système optique de projection, destiné à former un faisceau d'éclairage projeté sur la route.

Pour des raisons notamment thermiques et de rendement lumineux, il est souvent préférable d'utiliser un convertisseur fonctionnant en réflexion.

Toutefois, dans ce cas, interviennent des pertes, liées notamment aux réflexions parasites au point d'incidence du faisceau laser sur la surface d'entrée du convertisseur de longueur d'onde, comme aux réflexions totales également parasites du faisceau à l'intérieur du matériau formant le convertisseur, conduisant à l'absorption d'une partie du faisceau ou encore sa déviation hors de l'angle de sortie souhaité vers le système optique de projection. Ces mécanismes sont amplifiés par le fait que le convertisseur doit être à une distance du système de projection qui soit suffisante pour permettre au faisceau laser de venir frapper le convertisseur.

### BREF RESUME DE L'INVENTION

L'invention a pour but de pallier ces inconvénients en permettant de minimiser les pertes lumineuses et d'améliorer l'efficacité du dispositif lumineux et, ce, au moindre coût.

A cet effet, l'invention a pour objet un dispositif optique comportant au moins un élément optique convertisseur de longueur d'onde, formé d'un premier milieu optique ayant un premier indice de réfraction, l'élément convertisseur étant configuré pour recevoir un faisceau lumineux incident sur une première de ses faces et pour convertir le faisceau lumineux incident en un faisceau lumineux converti.
Le dispositif est remarquable en ce qu'il comporte en outre :
- un élément optique réfléchissant, disposé sur une deuxième des faces du convertisseur, la deuxième face étant opposée à la première face, l'élément réfléchissant étant configuré pour réfléchir le faisceau lumineux converti ;
- un élément optique dit primaire, formé d'un deuxième milieu optique ayant un deuxième indice de réfraction sensiblement identique au premier indice de réfraction, l'élément primaire ayant une première de ses faces disposée à proximité de la première face de l'élément convertisseur, l'élément primaire étant configuré pour recevoir le faisceau lumineux incident et le transmettre au convertisseur, l'élément primaire ayant une deuxième de ses faces formant la face de sortie de l'élément primaire pour le faisceau lumineux converti, la deuxième face de l'élément primaire étant configurée pour minimiser les réflexions parasites du faisceau lumineux converti sur elle-même.

Ainsi, l'invention prévoit l'addition d'un élément optique dit primaire, traversé par le faisceau lumineux avant son impact sur le convertisseur de longueur d'onde comme après sa conversion, l'élément primaire ayant un indice de réfraction aussi proche que possible de celui du matériau convertisseur de longueur d'onde, et ayant une face de sortie configurée pour minimiser les réflexions parasites du faisceau lumineux sur cette face, dans le sens sortant et avantageusement dans le sens entrant également. Avantageusement, la face de sortie est de forme sensiblement sphérique.
L'invention permet donc d'améliorer les performances du dispositif dans laquelle elle est intégrée, à un coût limité à celui d'une seule pièce optique supplémentaire.

Selon différents modes de réalisation de l'invention, qui pourront être pris ensemble ou séparément :
- la deuxième face de l'élément primaire est convexe
- la deuxième face de l'élément primaire est sensiblement en forme de calotte sphérique ;
- la calotte sphérique est sensiblement centrée sur la première face de l'élément primaire ;
- l'élément primaire comporte une partie dite d'entrée configurée pour recevoir le faisceau lumineux incident ;
- la partie d'entrée de l'élément primaire est disposée excentrée par rapport à l'élément optique convertisseur de longueur d'onde ;
- la deuxième face de l'élément primaire est, dans la partie d'entrée, bombée de façon concave ;
- la deuxième face de l'élément primaire est, dans la partie d'entrée, en forme de calotte sphérique ;
- la première face de l'élément primaire est disposée sensiblement sur la première face de l'élément convertisseur ;
- l'élément primaire et l'élément convertisseur sont jointifs ;
- l'élément primaire est collé sur l'élément convertisseur ;
- l'élément primaire est surmoulé sur l'élément convertisseur ;
- l'élément primaire est en un même matériau que l'élément convertisseur ;
- le matériau formant l'élément convertisseur comporte des grains, assurant la conversion de longueur d'onde, notamment noyés dans un liant ;
- le faisceau lumineux incident est monochromatique ;
- le faisceau lumineux incident est fourni par une source laser ;
- la deuxième face de l'élément primaire est plane et micro structurée de sorte à minimiser les réflexions totales sur cette face.

L'invention se rapporte également à un module lumineux comportant un dispositif optique comme spécifié ci-dessus, et qui comporte en outre une source lumineuse fournissant le faisceau lumineux incident, des moyens de balayage du faisceau lumineux disposés en amont de l'élément optique primaire, et un objectif recevant le faisceau lumineux issu de la deuxième face de l'élément primaire.
Avantageusement, la calotte sphérique formant la deuxième face de la partie d'entrée de l'élément primaire est centrée sur les moyens de balayage.
Avantageusement, les moyens de balayage comportent un dispositif à miroir oscillant, par exemple de type MEMS (initiales de Micro Electro-Mechanical System en anglais pour micro système électromécanique), imprimant au faisceau incident un balayage à une ou deux dimensions.

L'invention se rapporte enfin à un dispositif d'éclairage et/ou de signalisation, notamment pour véhicule automobile, comprenant un tel module.

### BREVE DESCRIPTION DES FIGURES

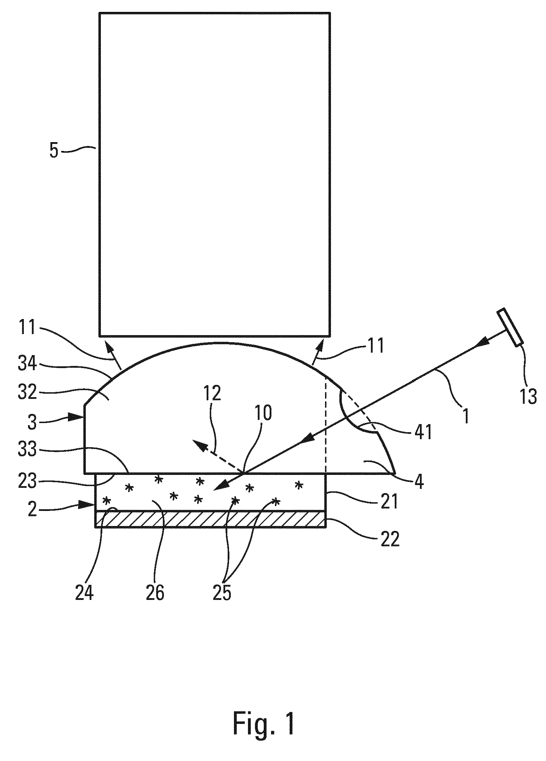

D'autres caractéristiques et avantages de l'invention ressortiront de la description détaillée qui suit, donnée à titre indicatif et illustrée par les dessins annexés, dans lesquels la figure 1 est une vue schématique en coupe partielle d'un mode de réalisation d'un dispositif lumineux selon l'invention.

### DESCRIPTION DETAILLEE DES FIGURES

Sur la figure 1, on a représenté un élément optique convertisseur de longueur d'onde 2, destiné à produire un faisceau lumineux sensiblement de couleur blanche à partir d'un faisceau lumineux incident 1 monochromatique.

Le faisceau 1 est par exemple produit par une ou plusieurs sources laser, par exemple des diodes laser, et est alors typiquement de couleur bleue.

Le faisceau 1 peut avoir subi différents traitements optiques avant son arrivée sur le convertisseur 2, comme par exemple être passé par des moyens lui imprimant un balayage à une ou deux dimensions et/ou des moyens de diffusion pour élargir le spot laser.
De ces différents traitement, opérés de façon classique, on a seulement illustré sur la figure un dispositif à miroir oscillant 13, par exemple de type MEMS (initiales de Micro Electro-Mechanical System en anglais pour micro système électromécanique), imprimant au faisceau 1 un balayage à une ou deux dimensions.

Le convertisseur 2 comporte un matériau optique 21 assurant la conversion de longueur d'onde et un matériau réflecteur 22.
Le matériau convertisseur 21 est formé de toute façon connue, par exemple de grains 25, assurant la conversion de longueur d'onde, noyés dans un liant 26. Les grains 25 peuvent être formés de grenats d'Yttrium-Aluminium (connus sous le nom de YAG pour Yttrium Aluminium Garnet en anglais) et d'Europium. Le liant est par exemple un matériau à base de silicone.
Le convertisseur 2 est par exemple en forme générale de plaquette, le faisceau laser étant reçu sur une première face 23 du matériau convertisseur 21 et le matériau réflecteur 22 étant disposé du côté d'une deuxième face 24 du matériau 21, opposée à la face 23. Le matériau réflecteur 22 est avantageusement accolé à la face 24 par tout moyen connu, colle, surmoulage ou autre. Dans le cas d'un collage, on utilise une colle dite « d'indice », transparente et ayant un indice de réfraction aussi proche que possible de la moyenne géométrique des indices des matériaux assemblés. Le milieu réflecteur est par exemple en aluminium, matériau qui présente notamment de bonnes qualités de dissipation thermique.

Selon l'invention, on interpose sur le trajet du faisceau 1 un élément optique 3, dit élément optique primaire, dont l'indice de réfraction est sensiblement identique, c'est à dire aussi voisin que possible et avantageusement égal à celui de l'élément convertisseur 2. Il est par exemple formé du même matériau que le liant de la couche 21. A titre d'exemple, l'élément 3 peut être réalisé en poly méthacrylate de méthyle (matériau connu sous l'acronyme anglo-saxon PMMA), polycarbonate ou silicone, ou encore en verre.

Cet élément primaire 3 est disposé à proximité de la face 23 du convertisseur 2, aussi proche que possible de celle-ci, de préférence jointive, par exemple collé par une de ses faces 33 sur la face 23 avec une colle optique d'indice de réfraction sensiblement égal à celui des éléments 2 et 3, ou surmoulé sur l'élément 2, sur la face 23.

L'élément optique primaire 3 reçoit le faisceau laser 1 sur une autre de ses faces, repérée 34, sensiblement en vis à vis de la face 33. Le faisceau laser pénètre donc dans l'élément primaire 3 par la face 34, traverse l'élément primaire pour venir pénétrer dans le matériau convertisseur 21. Puis le faisceau laser est réfléchi par l'élément réfléchissant 22 en direction de la face 34 de l'élément optique primaire 3. A l'intérieur du matériau convertisseur 21, les impacts du faisceau laser sur les grains 25 provoquent, après absorption dans le réseau cristallin des grains puis réémission, un changement de la longueur d'onde des photons constituant le faisceau incident, phénomène qui s'accompagne d'une certaine diffusion de ce faisceau.
En outre, avantageusement, on ajoute au liant 26 du convertisseur 2 des grains (non représentés) ayant pour fonction de diffuser le faisceau incident, de sorte à éviter toute dangerosité du dispositif.

Le faisceau sortant de l'élément primaire 3 est alors récupéré par un objectif 5 de projection du faisceau, par exemple pour l'éclairage de la route dans une application d'éclairage automobile.

On a représenté par deux flèches 11 les trajets limites du faisceau laser issu de l'élément primaire 3 pour qu'il soit utilisable par l'objectif 5.

Selon l'invention, la face 34 de l'élément primaire 3 est configurée pour minimiser les réflexions parasites du faisceau laser sur cette face.
A cet effet, elle est par exemple bombée de façon convexe, avantageusement sensiblement en forme de calotte sphérique, la sphère étant alors de préférence sensiblement centrée sur l'interface 23-33, dans une zone 10 d'impact du faisceau laser sur cette interface.

De la sorte, les indices de réfraction des éléments 2 et 3 étant proches ou, de préférence, identiques, les réflexions totales du faisceau laser sur la face 23 sont très fortement minimisées, évitant ainsi les phénomènes de guidage de la lumière dans le matériau convertisseur 21 qui peuvent se traduire par une sortie d'une partie de la lumière hors de la zone utilisable, ou encore par une absorption partielle de la lumière, et donc par des pertes lumineuses.
De plus, les réflexions parasites du faisceau laser incident sur la surface 33 de l'élément primaire, schématisées par une flèche 12 pointillée, sont minimisées pour la même raison, ce qui évite qu'une partie de la lumière soit perdue ou ne soit directement transmise à l'objectif, sans passer par le convertisseur de longueur d'onde.
En outre, la forme de la face 34 de l'élément primaire 3 permet de fortement minimiser les pertes par réflexion sur cette face, en sortie du rayon laser, ce dernier impactant la surface 34 avec une incidence sensiblement nulle ou très faible.
Enfin, la présence de l'élément primaire 3 et la forme convexe de sa surface 34 permettent de concentrer la lumière qui est diffusée dans toutes les directions par le convertisseur, vers l'objectif 5.

Selon une variante de l'invention, la partie de l'élément optique primaire 3 qui reçoit le faisceau laser incident 1, partie repérée 4, est adaptée en ce que la face 34 est modifiée dans la zone recevant le faisceau laser : cette zone, repérée 41, est également bombée mais de façon concave, avantageusement sensiblement en forme de calotte sphérique, de préférence centrée sur le dispositif de balayage 13. De la sorte, le faisceau laser arrive sur la partie 4 de l'élément primaire 3 avec une incidence sensiblement nulle et les réflexions parasites du faisceau 1 sur la surface 41 sont minimisées, maximisant ainsi le flux lumineux transmis.

Il est à noter que les courbures de la face 34, y compris le cas échéant celle de la zone 41, doivent être prises en compte classiquement dans le calcul optique de l'objectif 5.

En outre, de préférence la partie 4 d'entrée du faisceau laser 1 dans l'élément primaire 3 est disposée excentrée par rapport au convertisseur 2, c'est à dire déportée latéralement, de manière à ne pas intercepter de lumière émise par le convertisseur et susceptible d'entrer dans l'objectif de projection.

Selon une autre variante de l'invention, non représentée, la face 34 de l'élément primaire 3 n'est pas convexe mais plane et micro structurée pour, de façon connue, minimiser les phénomènes de réflexion totale et faciliter l'extraction de la lumière.
A titre d'exemple, ces micro structurations peuvent être des micro cônes, des micro sphères, des structures aléatoires, ou encore des réseaux de diffraction accordés sur la longueur d'onde du faisceau laser pour sensiblement annuler toute réflexion partielle à une incidence donnée.

On a ainsi décrit un dispositif optique permettant de minimiser les réflexions parasites et réflexions totales aux interfaces des différents éléments le constituant, de minimiser les pertes optiques, optimisant ainsi le flux sortant du dispositif vers l'objectif 5, et cela d'une façon simple, impliquant l'ajout d'une unique pièce optique, l'élément primaire 3, simple à réaliser et assurant en outre la protection mécanique du convertisseur de longueur d'onde 2.

## Revendications

1. Dispositif optique comportant au moins un élément optique convertisseur de longueur d'onde (21), formé d'un premier milieu optique ayant un premier indice de réfraction, l'élément convertisseur étant configuré pour recevoir un faisceau lumineux incident (1) sur une première (23) de ses faces et pour convertir le faisceau lumineux incident en un faisceau lumineux converti,
le dispositif étant **caractérisé par le fait qu'**il comporte en outre :
- un élément optique réfléchissant (22), disposé sur une deuxième (24) des faces du convertisseur, la deuxième face étant opposée à la première face, l'élément réfléchissant étant configuré pour réfléchir le faisceau lumineux converti;
- un élément optique dit primaire (3), formé d'un deuxième milieu optique ayant un deuxième indice de réfraction sensiblement identique au premier indice de réfraction, l'élément primaire ayant une première de ses faces (33) disposée à proximité de la première face (23) de l'élément convertisseur (21), l'élément primaire étant configuré pour recevoir le faisceau lumineux incident et le transmettre au convertisseur, l'élément primaire ayant une deuxième de ses faces (34) formant la face de sortie de l'élément primaire pour le faisceau lumineux converti, la deuxième face de l'élément primaire étant configurée pour minimiser les réflexions parasites du faisceau lumineux converti sur elle-même.

2. Dispositif selon la revendication 1, **caractérisé par le fait que** la deuxième face (34) de l'élément primaire (3) est convexe.

3. Dispositif selon l'une des revendications précédentes, **caractérisé par le fait que** la deuxième face (34) de l'élément primaire (3) est sensiblement en forme de calotte sphérique.

4. Dispositif selon la revendication 3, **caractérisé par le fait que** la calotte sphérique est sensiblement centrée sur la première face (33) de l'élément primaire.

5. Dispositif selon l'une des revendications précédentes, **caractérisé par le fait que** l'élément primaire comporte une partie dite d'entrée (4) configurée pour recevoir le faisceau lumineux incident et disposée excentrée par rapport à l'élément optique convertisseur de longueur d'onde.

6. Dispositif selon la revendication précédente, dans lequel la deuxième face de l'élément primaire est, dans la partie d'entrée (4), bombée de façon concave (41).

7. Dispositif selon la revendication 6, **caractérisé par le fait que** la deuxième face de l'élément primaire est, dans la partie d'entrée, en forme de calotte sphérique (41).

8. Dispositif selon l'une des revendications précédentes, **caractérisé par le fait que** l'élément primaire est collé sur l'élément convertisseur.

9. Dispositif selon l'une des revendications précédentes, **caractérisé par le fait que** l'élément primaire (3) est surmoulé sur l'élément convertisseur (2), en un même matériau que l'élément convertisseur.

10. Dispositif selon l'une des revendications précédentes, **caractérisé par le fait que** le faisceau lumineux incident (1) est monochromatique.

11. Dispositif selon l'une des revendications précédentes, **caractérisé par le fait que** le faisceau lumineux incident (1) est fourni par une source laser.

12. Dispositif selon la revendication 1, **caractérisé par le fait que** la deuxième face (34) de l'élément primaire (3) est plane et micro structurée de sorte à minimiser les réflexions totales sur cette face.

13. Module lumineux comportant un dispositif optique selon l'une des revendications précédentes, **caractérisé par le fait qu'**il comporte en outre une source lumineuse fournissant le faisceau lumineux incident, des moyens de balayage (13) du faisceau lumineux disposée en amont de l'élément optique primaire (3), et un objectif (5) recevant le faisceau lumineux issu de la deuxième face (34) de l'élément primaire.

14. Module lumineux selon la revendication 13, dans lequel le dispositif optique est selon la revendication 7 et dans lequel la calotte sphérique est centrée sur les moyens de balayage.

15. Dispositif d'éclairage et/ou de signalisation notamment pour véhicule automobile, **caractérisé par le fait qu'**il comporte un module selon l'une des revendications précédentes.
